# EUROPÄISCHE PATENTSCHRIFT

(11) **EP 1 597 212 B1**
(45) Veröffentlichungstag und Bekanntmachung des Hinweises auf die Patenterteilung: **24.10.2012**
(21) Anmeldenummer: 04704588.5
(22) Anmeldetag: 23.01.2004
(51) Int. Cl.: C03C 17/245

(54) **AUFDAMPFMATERIAL ZUR HERSTELLUNG HOCHBRECHENDER OPTISCHER SCHICHTEN**
VAPORIZING MATERIAL FOR PRODUCING HIGHLY REFRACTIVE OPTICAL LAYERS
MATIERE DE VAPORISATION POUR PRODUIRE DES COUCHES OPTIQUES A HAUTE REFRACTION

(30) Priorität: 19.02.2003 DE 10307095
(43) Veröffentlichungstag der Anmeldung: 23.11.2005
(73) Patentinhaber: Merck Patent GmbH, 64293 Darmstadt (DE)
(72) Erfinder: FRIZ, Martin, 64297 Darmstadt (DE); DOMBROWSKI, Reiner, 64739 Höchst (DE); ANTHES, Uwe, 64711 Erbach (DE)
(86) Internationale Anmeldenummer: PCT/EP2004/000554
(87) Internationale Veröffentlichungsnummer: WO 2004/074200

(56) Entgegenhaltungen:
- EP-A- 0 792 852
- US-B1- 6 258 467
- US-B1- 6 365 281
- ZASLAVSKII, A. M. ET AL: "Synthesis and structure of R2TiO5 thin films" JOURNAL OF MATERIALS SCIENCE LETTERS , 12(5), 350-1 CODEN: JMSLD5; ISSN: 0261-8028, 1993, XP002284914
- KUSHKOV, V. D. ET AL: "Structure of the lanthanide titanium oxide (Ln2Ti2O7) thin films prepared by pulsed-laser evaporation" JOURNAL OF MATERIALS SCIENCE , 28(2), 361-3 CODEN: JMTSAS; ISSN: 0022-2461, 1993, XP002284915

## Beschreibung

Die Erfindung betrifft ein Aufdampfmaterial zur Erzeugung hochbrechender optischer Schichten, welches Titanoxid im Gemisch mit Ytterbiumoxid enthält.

Optische Bauteile werden gewöhnlich mit dünnen Beschichtungen versehen, welche zum Schutz der Oberflächen oder zur Erzielung bestimmter optischer Eigenschaften aufgebracht werden.
Bei derartigen optischen Bauteilen handelt es sich beispielsweise um optische Linsen, Brillengläser, Objektive für Kameras, Ferngläser oder für andere optische Geräte, um Strahlteiler, Prismen, Spiegel, Fensterscheiben und dergleichen.
Die Beschichtungen dienen einerseits zur Vergütung der genannten Oberflächen durch Härtung und/oder Erhöhung der chemischen Resistenz um Schädigungen durch mechanische, chemische oder Umwelteinflüsse zu vermindern oder zu vermeiden, andererseits aber oft auch zur Erzielung einer verminderten Reflexion, was insbesondere bei Brillengläsern und Objektiven der Fall ist. Durch Auswahl geeigneter Beschichtungsmaterialien, verschiedener Schichtdicken und ein- oder mehrschichtiger Schichtaufbauten aus gegebenenfalls unterschiedlichen Materialien mit verschiedenen Brechzahlen kann dabei eine Reduktion der Reflexion auf unter 1 % über das gesamte sichtbare Strahlungsspektrum erzielt werden. Auf diese Weise können auch Interferenzspiegel, Strahlteiler, Polarisatoren, Wärmefilter oder Kaltlichtspiegel hergestellt werden.

Zur Erzeugung der oben genannten Vergütungsschichten sind verschiedene, insbesondere oxidische Materialien bekannt, wie beispielsweise SiO₂, TiO₂, ZrO₂, MgO, Al₂O₃, aber auch Fluoride wie MgF₂ sowie Gemische dieser Stoffe.

Die Auswahl der Beschichtungsmaterialien erfolgt dabei nach den angestrebten optischen Eigenschaften und nach der Verarbeitbarkeit der Materialien.

Die Beschichtung von optischen Substraten wird üblicherweise mit einem Hochvakuumaufdampfverfahren durchgeführt. Hierbei wird zunächst das Substrat und eine die Aufdampfsubstanz enthaltende Vorlage in einer geeigneten Hochvakuumaufdampfapparatur platziert, anschließend die Apparatur evakuiert und die Aufdampfsubstanz durch Erhitzen und/oder Elektronenstrahlbeschuss zur Verdampfung gebracht, wobei sich das Aufdampfmaterial als dünne Schicht auf der Substratoberfläche niederschlägt. Entsprechende Apparaturen und Verfahren sind gängiger Stand der Technik.

Die Auswahl an Ausgangsstoffen, die sich zur Herstellung von Schichten mit hoher Brechzahl, d.h. mit einer Brechzahl von 2 oder größer, eignen, ist vergleichsweise begrenzt. Im wesentlichen kommen hier die Oxide des Titans, Zirkoniums, Hafniums und Tantals sowie deren Mischoxide in Betracht. Am häufigsten wird Titanoxid eingesetzt. Die daraus hergestellten Schichten sind im sichtbaren und im nahen infraroten Spektralbereich von etwa 380 nm bis 5 µm transparent und sollten, so wie das Ausgangsmaterial, keine wesentliche Absorption aufweisen. Die mit Titanoxid bei einer Wellenlänge um 500 nm erreichbare Brechzahl liegt bei etwa 2,4. Unter UV-Bestrahlung wird jedoch Absorption beobachtet.

Auch tritt insbesondere bei reinem Titan(IV)oxid die Gefahr auf, dass es bei der Verdampfung zu einem Sauerstoffverlust kommt, welcher zur Abscheidung unterstöchiometrischer Titanoxidschichten und damit zu im sichtbaren Bereich absorbierenden Schichten führt. Dies kann durch geeignete Maßnahmen bei der Verdampfung, wie z.B. das Einstellen eines Sauerstoffrestdruckes, oder auch durch den Zusatz bestimmter Stoffe, wie beispielsweise gemäß DE-PS 12 28 489 von Elementen oder Oxiden aus der Gruppe der seltenen Erden, verhindert werden. Hier wurden unter anderem Gemische von Titanoxid mit Praseodym und/oder Praseodymoxid oder auch Gemische von Titanoxid mit Cer und/oder Ceroxid genannt. Gemische von Titanoxid mit Ytterbiumoxid sind nicht beschrieben worden.

Die relative Absorptionsfreiheit dieser bekannten Gemische beschränkt sich jedoch auf den sichtbaren Spektralbereich. Über den ultravioletten oder den nahen infraroten Spektralbereich ist dagegen in der DE-PS 12 28 489 keine Aussage getroffen worden.

Ein weiterer Nachteil der reinen Oxide besteht darin, dass sie in der Regel hohe Schmelz- und Siedepunkte aufweisen, die darüber hinaus auch noch dicht beieinander liegen. Aus verarbeitungstechnischen Gründen ist es jedoch empfehlenswert, dass die Aufdampfmaterialien vor Beginn einer merklichen Verdampfung vollständig aufgeschmolzen sind. Nur so kann eine gleichmäßige und ausreichende Abdampfrate erzielt werden, die zur Ausbildung homogener und gleichmäßig dicker Schichten erforderlich ist. Unter den üblichen Arbeitsbedingungen treten jedoch insbesondere bei den Oxiden des Zirkons und Hafniums, wie auch bei Titan-Zirkon-Mischoxiden Schwierigkeiten bezüglich des Aufschmelzens ein.
Die entstehenden Schichten sind oft optisch inhomogen und führen bei der üblichen Mehrfachaufbringung zu Schwierigkeiten bei der Reproduzierbarkeit der Brechzahlen.

Aus diesem Grunde werden den reinen Metalloxiden auch Materialien zugesetzt, welche den Schmelzpunkt des Metalloxids herabsetzen sollen und unter anderem auch zur gezielten Variation der Brechzahlen eingesetzt werden.
Diese Materialien sind jedoch so auszuwählen, dass es bei den ausgebildeten Schichten zu keiner merklichen Absorption im sichtbaren Bereich kommt.

Es hat sich jedoch als nachteilig herausgestellt, dass Gemische der oben genannten Metalloxide mit den Schmelzpunkt herabsetzenden Zusätzen inkongruent verdampfen, d.h. dass sie im Verlaufe des Verdampfungsprozesses ihre Zusammensetzung verändern und entsprechend auch die Zusammensetzung der abgeschiedenen Schicht verändert wird.

Zur Lösung dieses Problems wurden Mischoxide wie beispielsweise La₂Ti₂O₇ vorgeschlagen. Diese geben jedoch beim Verdampfen, ähnlich wie Titan(IV)oxid, Sauerstoff ab, so dass es zu unterstöchiometrischer Zusammensetzung der abgeschiedenen Schichten und damit zu Absorptionserscheinungen kommt.

Außer den oben bereits genannten Metalloxiden, welche sich für die Herstellung hochbrechender Schichten eignen, sind auch in anderen Veröffentlichungen bereits Oxide der seltenen Erdmetalle genannt worden.

So sind zum Beispiel Mischungen aus Praseodymoxid und Titandioxid bekannt. Diese weisen im Spektralbereich von kleiner als 400 nm eine starke und im sichtbaren Spektralbereich eine schwache Absorption auf, welche durch die Absorption des Praseodym-Ions verursacht wird.

Auch sind bereits mehrfach Gemische aus Lanthanoxid und Titanoxid, beispielsweise in DE 42 08 811 sowie in DE 100 65 647, vorgeschlagen worden. Der Anteil an Lanthanoxid führt jedoch bei den damit erzeugten Schichten zu einer erhöhten Empfindlichkeit gegenüber Feuchtigkeit. Zusätzlich kann das natürliche radioaktive Isotop des Lanthans durch seine radioaktive Strahlung an empfindlichen optischen Bauteilen zu Schädigungen führen.

In der US 4,794,607 ist der Einsatz von Gadoliniumoxidschichten im Wechsel mit Aluminiumoxidschichten beschrieben, die als Antireflexionsbeschichtung für einen optischen Verstärker dienen. Untersuchungen an diesem Material haben ergeben, dass mit Gadoliniumoxid homogene Schichten durch Aufdampfen erhalten werden können, die je nach der Art ihrer Aufbringung Brechzahten von 1,75 oder 1,80 aufweisen (K. Truszkowska, C. Wesolowska, "Optical properties of evaporated gadolinium oxide films in the region 0.2-5 µm", Thin Solid Films (1976), 34(2), 391-4). Damit sind die erzeugten Schichten von einer angestrebten Brechzahl von 2 oder größer weit entfernt.

Aus der DE-OS 3335557 ist es bekannt, abwechselnd Schichten aus Titandioxid und Ytterbiumoxid oder Schichtfolgen aus Aluminiumoxid und Ytterbiumoxid zur Erzeugung von Antireflexionsbeschichtungen auf optischen Linsen zu verwenden.
Von Ytterbiumoxid ist bekannt, dass es je nach Dicke der aufgetragenen Schichten und abhängig vom Auftragsverfahren Brechzahlen von 1,75 bis 1,9 erzielen kann. Auch diese Brechzahlen liegen nicht im hochbrechenden Bereich.

Weiterhin sind auch Gemische aus Titanoxid mit Dysprosiumoxid und /oder Ytterbiumoxid bekannt, welche aber nach WO 95/05670 zur Erzeugung halbleitender Metalloxidschichten im Sol/Gel-Verfahren auf Photovoltaikzellen aufgebracht werden.
Über erzielbare Brechzahlen der erzeugten Schichten wird nichts ausgesagt.

Aus der JP-A-03-129301 ist eine mehrlagige Membrane mit Antireflexionseigenschaften bekannt, welche in den hochbrechenden Schichten Titandioxid, Ytterbiumoxid oder deren Gemische enthalten kann. Beispiele für Gemische aus Titandioxid und Ytterbiumoxid sowie die damit erzielbaren Brechzahlen sind jedoch nicht erwähnt. -

In der DE-OS 196 07 833 ist ein gesintertes Aufdampfgemisch aus TiOₓ mit x= 1,4 bis 1,8 beschrieben worden, welches zur mechanischen Stabilisierung der aus diesem Material bestehenden Formkörper 0,1 bis 10 Gew. % Ytterbiumoxid enthalten kann. Der Zusatz des Stabilisierungsmittels darf dabei die optischen Eigenschaften der TiOₓ-Schicht nicht verschlechtern. Es ist jedoch kein Beispiel für ein Gemisch aus Titanoxid und Ytterblumoxid beschrieben worden. Welche Brechzahlen sich hiermit erzielen lassen, ist nicht bekannt. Welchen Einfluss der Zusatz des Stabilisierungsmittels auf die physikalischen Eigenschaften der damit erzielbaren Schichten ausübt, ist ebenfalls nicht beschrieben worden.

Die Aufgabe der vorliegenden Erfindung bestand darin, ein Aufdampfmaterial zur Herstellung von Schichten mit einer hohen Brechzahl von mindestens 2,0 zur Verfügung zu stellen, welches eine hohe Haltbarkeit aufweist, gegen Feuchtigkeit, Säuren und Alkalien wenig empfindlich ist, eine geringe Radioaktivität besitzt, über einen breiten Spektralbereich transparent und nicht absorbierend ist und beim Einschmelzen und Verdampfen seine ursprüngliche Zusammensetzung nicht verändert und welches zur Herstellung hochbrechender Schichten mit den gleichen Eigenschaften geeignet ist.

Diese Aufgabe wird gemäß der vorliegenden Erfindung durch ein Aufdampfmaterial zur Herstellung hochbrechender optischer Schichten, enthaltend Titanoxid und Ytterbiumoxid in einem molaren Verhältnis von 4:1 bis 1:4 und Gadoliniumoxid und/oder Dysprosiumoxid und/oder Titan, gelöst.

Die erfindungsgemäße Aufgabe wird weiterhin gelöst durch ein Verfahren zur Herstellung eines Aufdampfmaterials zur Erzeugung hochbrechender optischer Schichten, wobei Titanoxid mit Ytterbiumoxid im molaren Verhältnis von 4:1 bis 1:4 gemischt, die Mischung komprimiert oder suspendiert, geformt und anschließend gesintert wird wobei zusätzlich Gadoliniumoxid und/oder Dysprosiumoxid und/oder Titan zugesetzt wird.

Gegenstand der Erfindung ist darüber hinaus die Verwendung eines Aufdampfmaterials enthaltend Titanoxid und Ytterbiumoxid im molaren Verhältnis von 4:1 bis 1:4 zur Herstellung hochbrechender optischer Schichten auf Glas-und Kunststoffsubstrate

In einer erfindungsgemäßen Ausführungsform enthält das Aufdampfmaterial Titandioxid und Ytterbiumoxid (Yb₂O₃) in einem molaren Verhältnis von 4:1 bis 1:4.
Bevorzugt liegen die Materialien in einem molaren Verhältnis von 2,6:1 bis 1:1,3 vor.

In einer weiteren Ausführungsform kann das erfindungsgemäße Aufdampfmaterial noch zusätzlich Gadoliniumoxid (Gd₂O₃) und/oder Dysprosiumoxid (Dy₂O₃) enthalten. Dabei ist es von Vorteil, wenn die Summe der molaren Anteile aus Ytterbiumoxid, Gadoliniumoxid und/oder Dysprosiumoxid 80 Mol % nicht übersteigt. Wenn ein solches Gemisch aus Ytterbiumoxid, Gadoliniumoxid und/oder Dysprosiumoxid eingesetzt wird, ist der relative Anteil der Einzelsubstanzen an sich nicht kritisch. Er kann in einem breiten Verhältnis eingestellt werden und liegt bei einem binären Gemisch im Verhältnis von 99:1 bis 1:99 und bei einem ternären Gemisch im Verhältnis 1:1:98 bis 1:98:1 bis 98:1:1.

Betrachtet man die Brechzahlen, welche sich durch Beschichtungen mit den Einzelkomponenten erzielen lassen, so liegen diese bei Beschichtungen mit Titandioxid bei etwa 2,3 bis 2,4, während, wie oben bereits erwähnt, mit reinen Ytterbiumoxidschichten Brechzahlen von etwa 1,75 bis 1,9 erhalten werden können.

In der Regel lassen sich mit Mischungen aus zwei Komponenten Schichten mit Brechzahlen erzielen, die je nach molarem Anteil der Komponenten zwischen den beiden Einzelwerten liegen. Ein relativ hoher molarer Anteil einer eher niedrig brechenden Komponente würde danach zu einer Brechzahl des Gemisches führen, die näher an der Brechzahl der niedrig brechenden Komponente liegt als an der Brechzahl der höher brechenden Komponente.

Es hat sich daher überraschend herausgestellt, dass sich mit Gemischen, welche Titandioxid und Ytterbiumoxid in den vorab beschriebenen molaren Anteilen enthalten, Schichten mit Brechzahlen erhalten lassen, welche deutlich höher als die zu erwartenden Mischwerte und insbesondere nahe an der Brechzahl von reinem Titandioxid liegen. Konkret lassen sich mit diesen Mischungen Schichten mit Brechzahlen von deutlich über 2,0, nämlich im Bereich von etwa 2,20 bis etwa 2,30, erzeugen. Dabei kann innerhalb dieses Bereiches die jeweils gewünschte definierte Brechzahl gezielt über den molaren Anteil an Ytterbiumoxid eingestellt werden. Ein höherer Anteil an dieser Komponente führt dann zu einer geringfügigen Absenkung der erhaltenen Brechzahl.

Wird statt reinem Ytterbiumoxid ein Gemisch aus Ytterbiumoxid mit Gadoliniumoxid und/oder Dysprosiumoxid eingesetzt, hat dagegen der relative Anteil dieser Substanzen im obigen Gemisch keinen bemerkenswerten Einfluß auf die Brechzahl, die mit dem Titandioxid-haltigen Gesamtgemisch erhalten werden kann, da die Brechzahlen von Ytterbiumoxid, Gadoliniumoxid und Dysprosiumoxid sich nicht wesentlich voneinander unterscheiden.

Des weiteren hat sich als vorteilhaft herausgestellt, dass die erfindungsgemäßen Aufdampfmaterialien kongruent verdampfen, d.h. dass sich ihre Zusammensetzung im Verlaufe des Verdampfungsprozesses praktisch nicht verändert. Dies gilt unabhängig davon, ob dem Titanoxid lediglich Ytterbiumoxid oder aber ein Gemisch aus Ytterbiumoxid mit Gadoliniumoxid und/oder Dysprosiumoxid zugesetzt wird. Auf diese Weise lassen sich homogene Schichten mit einer stabilen hohen Brechzahl von n ≥ 2,0, insbesondere von n ≥ 2,20 herstellen.

Die erhaltenen optischen Schichten weisen außerdem eine hohe Transparenz in einem breiten Spektralbereich auf, d.h. von etwa 380 nm bis 5 µm. Insbesondere kann im sichtbaren und im nahen infraroten Spektralbereich eine völlige Transparenz erzielt werden.

Gegenüber den aus dem Stand der Technik bekannten Aufdampfmaterialien zur Erzeugung hochbrechender Schichten weisen die aus dem erfindungsgemäßen Aufdampfmaterial hergestellten Schichten eine verbesserte Haltbarkeit auf. Dies ist insbesondere in feucht-warmer Umgebung der Fall, da das erfindungsgemäße Aufdampfmaterial nicht zur Aufnahme von Feuchtigkeit neigt. Diese Eigenschaft erweist sich schon bei der Herstellung des Aufdampfmaterials als sehr vorteilhaft, da spezielle Maßnahmen bei der Handhabung und Weiterverarbeitung der Gemische ausbleiben können. Aber auch die nach der Abscheidung auf geeigneten Substraten entstehenden hochbrechenden Schichten sind in feucht-warmer Umgebung besonders stabil. Ebenso kann gegenüber Säuren und Alkalien eine verbesserte Haltbarkeit festgestellt werden.

Ein weiterer Vorteil des Aufdampfmaterials der vorliegenden Erfindung liegt darin, dass die verwendeten Substanzen keine radioaktiven Isotope aufweisen. Weder das Aufdampfmaterial selbst noch die damit hergestellten Schichten strahlen daher radioaktiv, so dass Vorsichtsmaßnahmen unterbleiben können und eine diesbezügliche Schädigung von optischen Bauelementen oder Detektoren, welche mit den Schichten in Verbindung kommen, nicht zu erwarten ist.

In einer weiteren Ausführungsform der Erfindung enthält das Aufdampfmaterial zur Herstellung hochbrechender optischer Schichten Titandioxid, Titan und Ytterbiumoxid (Yb₂O₃), wobei das molare Verhältnis von Titanoxid zu Ytterbiumoxid 4:1 bis 1:4, bevorzugt jedoch 2,6:1 bis 1:1,3 beträgt. Auch hier kann statt reinem Ytterbiumoxid ein Gemisch aus Ytterbiumoxid, Gadoliniumoxid und/oder Dysprosiumoxid eingesetzt werden.

Durch den Zusatz von metallischem Titan wird hierbei ein unterstöchiometrisches Verhältnis der Mischung bezüglich Sauerstoff eingestellt. Dadurch wird eine Abgabe von Sauerstoff während des Einschmelzens und Verdampfens der Mischung vermieden. Dies verbessert auch die Handhabbarkeit des Aufdampfmaterials, da beim Einschmelzen und Verdampfen das sonst üblicherweise auftretende Spritzen verhindert werden kann. Das Gemisch erhält auf diese Weise eine besonders stabile Zusammensetzung, die sich während des gesamten nachfolgenden Verarbeitungsprozesses nicht verändert.

Für den Fall, dass ein Gemisch aus Ytterbiumoxid, Gadoliniumoxid und/oder Dysprosiumoxid zum Einsatz kommt, können innerhalb des molaren Anteils des Gemisches die molaren Anteile der Einzelsubstanzen im Gemisch bei einem binären Gemisch im Verhältnis 99:1 bis 1:99 und bei einem ternären Gemisch im Verhältnis 1:1:98 bis 1:98:1 bis 98:1:1 variiert werden.

Als besonders vorteilhaft hat sich ein Gemisch aus Titandioxid, Titan und Ytterbiumoxid erwiesen.

Bezüglich der Gewichtsteile werden vorteilhafterweise die folgenden Verhältnisse eingestellt: 50 bis 92 Gewichtsteile Ytterbiumoxid, 7 bis 42 Gewichtsteile Titandioxid sowie 0 bis 8 Gewichtsteile Titan, bezogen auf das Gesamtgewicht der Mischung.

Bevorzugt werden 67 bis 76 Gewichtsteile Ytterbiumoxid, 15 bis 27 Gewichtsteile Titandioxid und 2 bis 5 Gewichtsteile Titan, bezogen auf das Gesamtgewicht der Mischung, eingesetzt.

Bezüglich der erzielbaren Brechzahlen der mit dem Material erhaltenen optischen Schichten hat der Zusatz von metallischem Titan keine nachteiligen Auswirkungen. Auch hier können Brechzahlen von größer als 2,0 und insbesondere von 2,20 bis 2,30 erhalten werden.

Alle Vorteile, die oben bereits für das erfindungsgemäße Aufdampfmaterial ohne Titanzusatz beschrieben wurden, treffen auch auf die Gemische zu, die neben Titandioxid und Ytterbiumoxid noch metallisches Titan enthalten.

Das bedeutet, dass die Mischungen sich gut verarbeiten lassen und damit in einem breiten Spektralbereich nicht absorbierende, transparente, homogene Schichten mit stabiler hoher Brechzahl erhalten werden, welche darüber hinaus in feucht- warmer Umgebung stabil sind und keine radioaktive Strahlung abgeben.

Das erfindungsgemäße Aufdampfmaterial wird hergestellt, indem Titanoxid mit Ytterbiumoxid im molaren Verhältnis von 4:1 bis 1:4 gemischt, die Mischung komprimiert oder suspendiert, geformt und anschließend gesintert wird.

Vorteilhafterweise werden Titanoxid und Ytterbiumoxid in einem molaren Verhältnis von 2,6:1 bis 1:1,3 innig miteinander gemischt.

Statt reinem Ytterbiumoxid kann dabei auch ein Gemisch aus Ytterbiumoxid mit Gadoliniumoxid und/oder Dysprosiumoxid eingesetzt werden.

Das Gemisch wird mittels geeigneter, an sich bekannter Maßnahmen der Komprimierung verdichtet und geformt. Es kann jedoch auch eine Suspension der gemischten Komponenten in einem geeigneten Trägermedium hergestellt werden, welche geformt und anschließend getrocknet wird. Ein geeignetes Trägermedium ist beispielsweise Wasser, welchem je nach Bedarf Bindemittel wie Polyvinylalkohol, Methylzellulose oder Polyethylenglykol sowie gegebenenfalls Hilfsmittel, wie z.B. Netzmittel oder Entschäumer, zugesetzt werden. Nach dem Suspendieren erfolgt eine Formgebung. Hierbei können verschiedene bekannte Techniken, wie Strangpressen, Spritzgießen oder auch Sprühtrocknen Anwendung finden. Die erhaltenen Formen werden getrocknet und vom Bindemittel, beispielsweise durch Ausbrennen, befreit. Dies erfolgt aus Gründen einer besseren Handhabbarkeit und Dosierbarkeit der Mischungen. Daher sind die Formen, in welche das Gemisch gebracht wird, nicht limitiert. Geeignet sind alle Formen, welche eine einfache Handhabung und eine gute Dosierbarkeit ermöglichen, die insbesondere bei der kontinuierlichen Beschichtung von Substraten mit dem erfindungsgemäßen Aufdampfmaterial und dem dafür nötigen Nachfüllprozeß eine besondere Rolle spielen. Bevorzugte Formen sind daher verschiedene Tablettenformen, Pellets, Scheiben, Kegelstümpfe, Körner bzw. Granulate, Stangen oder auch Kugeln.

Anschließend werden die geformten Gemische gesintert. Der Sinterprozeß kann dabei unter verschiedenen Bedingungen durchgeführt werden. Beispielsweise kann in Luft bei Temperaturen von 1200 bis 1600°C, unter Inertgas wie z. B. Argon bei Temperaturen von 1200 bis 1600°C, oder im Vakuum bei Temperaturen von 1300 bis 1700 °C und einem Restdruck von unter 1 Pa gesintert werden. Dabei ist es von Vorteil, dass der Sinterprozeß nicht, wie sonst allgemein üblich, unbedingt im Vakuum durchgeführt werden muß. Dies erspart sowohl apparativen wie auch zeitlichen Aufwand.

Die entstehenden geformten Sinterprödukte bleiben in ihrer Form beim Lagern, Transportieren und beim Einfüllen in die Verdampfungsapparatur bestehen und sind in ihrer Zusammensetzung während des gesamten nachfolgenden Aufschmelz- und Verdampfungsprozesses stabil.

Ein besonders stabiles Aufdampfmaterial wird jedoch erhalten, wenn Titandioxid mit Titan und Ytterbiumoxid in einem molaren Verhältnis von Titandioxid zu Ytterbiumoxid von 4:1 bis 1:4 gemischt, komprimiert oder suspendiert, geformt und anschließend gesintert wird. Auch hier kann statt reinem Ytterbiumoxid ein Gemisch aus Ytterbiumoxid mit Gadoliniumoxid und/oder Dysprosiumoxid eingesetzt werden.

Besonders vorteilhaft ist wiederum ein molares-Mischungsverhältnis Titandioxid zu Ytterbiumoxid von 2,6:1 bis 1:1,3.

Bezüglich der Art der Formkörper und der Sinterbedingungen ergeben sich zu den oben genannten Angaben bezüglich der erfindungsgemäßen Aufdampfmaterialien ohne Zusatz von metallischem Titan keine Änderungen.

Vorzugsweise werden hier beim Mischen Gewichtsverhältnisse von 50 bis 92 Gewichtsteilen Ytterbiumoxid, 7 bis 42 Gewichtsteilen Titanoxid und 0 bis 8 Gewichtsteilen Titan, bezogen auf das Gesamtgewicht der Mischung, eingestellt. Besonders bevorzugt wird ein Gemisch aus 67 bis 76 Gewichtsteilen Ytterbiumoxid, 15 bis 27 Gewichtsteilen Titanoxid und 2 bis 5 Gewichtsteilen Titan, bezogen auf das Gesamtgewicht der Mischung, hergestellt.

Unter Einhaltung der oben genannten Mischungsverhältnisse hat sich ein Gemisch aus Ytterbiumoxid, Titandioxid und Titan als besonders vorteilhaft erwiesen.

Nach dem Sintern und Abkühlen ist das erfindungsgemäße Aufdampfmaterial anwendungsbereit zur Herstellung von hochbrechenden optischen Schichten mit einer Brechzahl von n ≥ 2,0, insbesondere n ≥ 2,20.

Es lassen sich alle geeigneten Substrate mit dem erfindungsgemäßen Aufdampfmaterial beschichten, insbesondere Scheiben, Prismen, Folien, geformte Substrate wie optische Linsen, Brillengläser und Objektive und dergleichen, welche aus den bekannten geeigneten Materialien wie verschiedenen Gläsern oder Kunststoffen bestehen können. Bezüglich Art, Größe, Form, Material und Oberflächenbeschaffenheit der zu beschichtenden Substrate ist die Anwendung der erfindungsgemäßen Aufdampfmaterialien daher keinerlei Beschränkungen unterworfen, sofern die Substrate in die Vakuumapparatur eingebracht werden können und bei den herrschenden Temperatur- und Druckverhältnissen stabil bleiben. Es hat sich jedoch als vorteilhaft herausgestellt, die Substrate zur Erhöhung der Dichte der aufgebrachten Schichten vor und während des Beschichtens zu erwärmen, so dass das Aufdampfmaterial auf ein vorgeheiztes Substrat trifft. Je nach Art der eingesetzten Substrate wird dabei auf Temperaturen bis zu 300°C erwärmt. Diese Maßnahme an sich ist jedoch bekannt.

Als Aufdampfverfahren wird üblicherweise ein Hochvakuumaufdampfverfahren eingesetzt, bei welchem das Aufdampfmaterial in einer geeigneten Vorlage, welche auch als Verdampfungstiegel oder-schiffchen bezeichnet wird, zusammen mit dem zu beschichtenden Substrat in eine Vakuumapparatur eingebracht wird.

Anschließend wird die Apparatur evakuiert und das Aufdampfmaterial durch Erhitzen und/oder Elektronenstrahlbeschuß zur Verdampfung gebracht. Dabei schlägt sich das Aufdampfmaterial als dünne Schicht auf dem Substrat nieder.

Während der Verdampfung wird vorteilhafterweise Sauerstoff zugesetzt, um die volle Oxydation der Schichten zu gewährleisten. Zur Verbesserung der Haftung der aufgebrachten Schichten auf insbesondere ungeheizten Substraten kann das Substrat während der Beschichtung mit Ionen beschossen werden (Ion Assisted Deposition, Plasma Assisted Deposition).

In der Regel werden abwechselnd mehrere Schichten übereinander abgeschieden, die zweckmäßigerweise abwechselnd hohe(n≥ 1,80) und niedrige (n ≥ 1,80) Brechzahlen aufweisen. Auf diese Weise entstehen mehrlagige Anordnungen, welche den damit beschichteten Substraten -unter anderem eine stark verminderte Reflexion verleihen-können. Solche mehrlagigen Anordnungen auf optischen Substraten an sich sind jedoch seit langem bekannt und werden häufig angewendet.

Mit den erfindungsgemäßen Aufdampfmaterialien lassen sich haftfeste hochbrechende optische Schichten auf geeigneten Substraten herstellen, welche in einem breiten Spektralbereich nicht absorbierend, transparent und homogen sind, eine hohe Brechzahl von insbesondere n ≥2,20 aufweisen, in feucht- warmer Umgebung sowie gegenüber Säuren und Alkalien stabil sind und keine radioaktive Strahlung abgeben.

Die Erfindung soll nachfolgend durch mehrere Beispiele erläutert werden, ohne sie jedoch darauf zu beschränken.

### Beispiel 1:

### Mischung aus Yb₂O₃ und TiO₂

83 Gewichtsteile Yb₂O₃ und 17 Gewichtsteile Titandioxid werden innig miteinander vermischt und anschließend zu Tabletten geformt. Diese werden an Luft bei etwa 1500 °C 4 Stunden lang geglüht. Die Tabletten werden anschließend in eine Aufdampfanlage mit Elektronenstrahl-Verdampfereinrichtung, beispielsweise vom Typ L560 der Fa. Leybold, eingebracht und bei Temperaturen von etwa 1900°C und einem Druck von 2x10⁻² Pa verdampft. Dabei wird auf den als Substraten in der Apparatur befindlichen Gläsern aus Quarzglas, welche vor der Bedampfung auf etwa 300 °C erhitzt worden waren, eine dünne Schicht abgeschieden. Die Dicke dieser Schicht wird auf etwa 340 nm eingestellt. Nach dem Abkühlen und der Entnahme aus der Verdampfungsapparatur werden die Transmissions- und Reflexionsspektren der beschichteten Gläser mit einem Spektralphotometer gemessen. Aus den Spektren wird die Brechzahl der Schicht ermittelt. Es werden homogene Schichten-erhalten, welche bei einer Wellenlänge von 500 nm eine Brechzahl von 2,24 aufweisen. Die Schichten sind im Spektralbereich von 400 nm bis etwa 5 µm transparent und weisen in diesem Bereich keine Absorption auf. Die Schichten sind in feucht-warmer Atmosphäre, z. B. bei 80 % relativer Luftfeuchte und 50°C, sowie gegenüber Säuren und Alkalien haltbar und besitzen eine gute Härte und Haftfestigkeit.

### Beispiel 2:

### Mischung aus Yb₂O₃, TiO₂ und Ti

72 Gewichtsteile Yb₂O₃, 25 Gewichtsteile Titandioxid und 3 Gewichtsteile Titan werden innig miteinander vermischt und anschließend zu Tabletten geformt. Diese werden im Vakuum bei etwa 1600 °C und einem Druck von 1x10⁻¹ Pa 4 Stunden lang geglüht. In einer Aufdampfanlage vom Typ L560 der Fa. Leybold werden die Tabletten unter den in Beispiel 1 beschriebenen Bedingungen verdampft. Dabei kann beim Einschmelzen und Verdampfen keine Sauerstoffabgabe (Spritzen) festgestellt werden. Es werden homogene Schichten erhalten, welche bei einer Wellenlänge von 500 nm eine Brechzahl von 2,22 aufweisen.

Die Schichten sind im Spektralbereich von 400 nm bis etwa 5 µm transparent und weisen in diesem Bereich keine-Absorption auf. Die Schichten sind ist in feucht-warmer Atmosphäre sowie gegenüber Säuren und Alkalien haltbar und besitzen eine gute Härte und Haftfestigkeit.

### Beispiel 3:

### Mischung aus Yb₂O₃, Gd₂O₃ und TiO₂

43 Gewichtsteile Yb₂O₃, 40 Gewichtsteile Gd₂O₃ und 17 Gewichtsteile Titandioxid werden innig miteinander vermischt und anschließend zu Tabletten geformt. Diese werden an Luft bei etwa 1500 °C 4 Stunden lang geglüht. In einer Aufdampfanlage vom Typ L560 der Fa. Leybold werden die Tabletten unter den in Beispiel 1 beschriebenen Bedingungen verdampft. Es werden homogene Schichten erhalten, welche bei einer Wellenlänge von 500 nm eine Brechzahl von 2,20 aufweisen. Die Schichten sind im Spektralbereich von 400 nm bis etwa 5 µm transparent und weisen in diesem Bereich keine Absorption auf. Die Schichten sind ist in feucht-warmer Atmosphäre sowie gegenüber Säuren und Alkalien haltbar und besitzen eine gute Härte und Haftfestigkeit.

### Beispiel 4:

### Mischung aus Yb₂O₃, Gd₂O₃, TiO₂ und Ti

48 Gewichtsteile Yb₂O₃, 24 Gewichtsteile Gd₂O₃, 25 Gewichtsteile Titandioxid und 3 Gewichtsteile Titan werden innig miteinander vermischt und anschließend zu Tabletten geformt. Diese werden im Vakuum bei etwa 1600 °C und einem Druck von 1x10⁻¹ Pa 6 Stunden lang geglüht. In einer Aufdampfanlage vom Typ L560 der Fa. Leybold werden die Tabletten unter den in Beispiel 1 beschriebenen Bedingungen verdampft. Dabei kann beim Einschmelzen und Verdampfen keine Sauerstoffabgabe (Spritzen) festgestellt werden. Es werden homogene Schichten erhalten, welche bei einer Wellenlänge von 500 nm eine Brechzahl von 2,21 aufweisen. Die Schichten sind im Spektralbereich von 400 nm bis etwa 5 µm transparent und weisen in diesem Bereich keine Absorption auf. Die Schichten sind ist in feucht-warmer Atmosphäre sowie gegenüber Säuren und Alkalien haltbar und besitzen eine gute Härte und Haftfestigkeit.

## Patentansprüche

1. Verwendung eines Aufdampfmaterials enthaltend Titanoxid und Ytterbiumoxid in einem molaren Verhältnis von 4:1 bis 1:4 zur Herstellung hochbrechender optischer Schichten auf Glas- und Kunststoffsubstraten.

2. Verwendung gemäß Anspruch 1, enthaltend Titandioxid und Ytterbiumoxid.

3. Verwendung gemäß Anspruch 1 oder 2, enthaltend Titanoxid und Ytterbiumoxid in einem molaren Verhältnis von 2,6:1 bis 1:1,3.

4. Verwendung gemäß einem der Ansprüche 1 bis 3, welches zusätzlich Gadoliniumoxid und/oder Dysprosiumoxid enthält.

5. Verwendung gemäß Anspruch 4, wobei die Summe der molaren Anteile aus Ytterbiumoxid, Gadoliniumoxid und/oder Dysprosiumoxid 80 Mol % nicht übersteigt.

6. Verwendung gemäß einem der Ansprüche 1 bis 5, enthaltend Titandioxid, Titan und Ytterbiumoxid.

7. Verwendung gemäß einem der Ansprüche 1 bis 6, enthaltend 50 bis 92 Gewichtsteile Ytterbiumoxid, 7 bis 42 Gewichtsteile Titandioxid und 0 bis 8 Gewichtsteile Titan, bezogen auf das Gesamtgewicht der Mischung.

8. Verwendung gemäß Anspruch 7, enthaltend 67 bis 76 Gewichtsteile Ytterbiumoxid, 15 bis 27 Gewichtsteile Titandioxid und 2 bis 5 Gewichtsteile Titan, bezogen auf das Gesamtgewicht der Mischung.

9. Aufdampfmaterial zur Herstellung hochbrechender optischer Schichten, enthaltend Titanoxid und Ytterbiumoxid in einem molaren Verhältnis von 4:1 bis 1:4 und Gadoliniumoxid und/oder Dysprosiumoxid und/oder Titan.

10. Aufdampfmaterial gemäß Anspruch 9, wobei die Summe der molaren Anteile aus Ytterbiumoxid, Gadoliniumoxid und/oder Dysprosiumoxid 80 Mol % nicht übersteigt.

11. Aufdampfmaterial gemäß einem der Ansprüche 9 bis 10, enthaltend Titandioxid, Titan und Ytterbiumoxid.

12. Aufdampfmaterial gemäß einem der Ansprüche 9 bis 11, enthaltend 50 bis 92 Gewichtsteile Ytterbiumoxid, 7 bis 42 Gewichtsteile Titandioxid und 0 bis 8 Gewichtsteile Titan, bezogen auf das Gesamtgewicht der Mischung.

13. Aufdampfmaterial gemäß einem der Ansprüche 9 bis 12, enthaltend 67 bis 76 Gewichtsteile Ytterbiumoxid, 15 bis 27 Gewichtsteile Titandioxid und 2 bis 5 Gewichtsteile Titan, bezogen auf das Gesamtgewicht der Mischung.

14. Verfahren zur Herstellung eines Aufdampfmaterials gemäß einem der Ansprüche 9 bis 13, wobei Titanoxid mit Ytterbiumoxid in einem molaren Verhältnis von 4:1 bis 1:4 gemischt, die Mischung komprimiert oder suspendiert, geformt und anschließend gesintert wird, wobei zusätzlich Gadoliniumoxid und/oder Dysprosiumoxid und/oder Titan zugesetzt wird.

15. Verfahren gemäß Anspruch 14, wobei Titandioxid mit Ytterbiumoxid gemischt wird.

16. Verfahren gemäß einem oder mehreren der Ansprüche 14 bis 15, wobei die Summe der molaren Anteile aus Ytterblumoxid, Gadoliniumoxid und/oder Dysprosiumoxid 80 Mol % nicht übersteigt.

17. Verfahren gemäß einem oder mehreren der Ansprüche 14 bis 16, wobei das Sintern unter Lufteinfluss stattfindet.

18. Verfahren gemäß einem oder mehreren der Ansprüche 14 bis 17, wobei das Sintern im Vakuum stattfindet.

19. Verfahren gemäß einem oder mehreren der Ansprüche 14 bis 18, wobei das Sintern unter Inertgas stattfindet.

20. Verfahren gemäß einem oder mehreren der Ansprüche 14 bis 19, wobei die Mischung zu Tabletten, Scheiben, Pellets, Kegelstümpfen, Körnern, Granulaten, Stangen oder Kugeln geformt wird.

21. Hochbrechende optische Schicht mit einer Brechzahl von n ≥ 2,0 auf einem Glas- oder Kunststoffsubstrat,, hergestellt unter Verwendung eines Aufdampfmaterials gemäß einem oder mehreren der Ansprüche 1 bis 8.

22. Mehrlagiges optisches System, umfassend mindestens eine hochbrechende optische Schicht mit einer Brechzahl von n ≥ 2,0 auf einem Glas- oder Kunststoffsubstrat hergestellt unter Verwendung eines Aufdampfmaterials gemäß einem oder mehreren der Ansprüche 1 bis 8.

## Claims

1. Use of a vapour-deposition material comprising titanium oxide and ytterbium oxide in a molar ratio of 4:1 to 1:4 for the production of optical layers of high refractive index on glass and plastic substrates.

2. Use according to Claim 1, comprising titanium dioxide and ytterbium oxide.

3. Use according to Claim 1 or 2, comprising titanium oxide and ytterbium oxide in a molar ratio of 2.6:1 to 1:1.3.

4. Use according to one of Claims 1 to 3, which additionally comprises gadolinium oxide and/or dysprosium oxide.

5. Use according to Claim 4, where the sum of the molar proportions of ytterbium oxide, gadolinium oxide and/or dysprosium oxide does not exceed 80 mol%.

6. Use according to one of Claims 1 to 5, comprising titanium dioxide, titanium and ytterbium oxide.

7. Use according to one of Claims 1 to 6, comprising 50 to 92 parts by weight of ytterbium oxide, 7 to 42 parts by weight of titanium dioxide and 0 to 8 parts by weight of titanium, based on the total weight of the mixture.

8. Use according to Claim 7, comprising 67 to 76 parts by weight of ytterbium oxide, 15 to 27 parts by weight of titanium dioxide and 2 to 5 parts by weight of titanium, based on the total weight of the mixture.

9. Vapour-deposition material for the production of optical layers of high refractive index, comprising titanium oxide and ytterbium oxide in a molar ratio of 4:1 to 1:4 and gadolinium oxide and/or dysprosium oxide and/or titanium.

10. Vapour-deposition material according to Claim 9, where the sum of the molar proportions of ytterbium oxide, gadolinium oxide and/or dysprosium oxide does not exceed 80 mol%.

11. Vapour-deposition material according to one of Claims 9 to 10, comprising titanium dioxide, titanium and ytterbium oxide.

12. Vapour-deposition material according to one of Claims 9 to 11, comprising 50 to 92 parts by weight of ytterbium oxide, 7 to 42 parts by weight of titanium dioxide and 0 to 8 parts by weight of titanium, based on the total weight of the mixture.

13. Vapour-deposition material according to one of Claims 9 to 12, comprising 67 to 76 parts by weight of ytterbium oxide, 15 to 27 parts by weight of titanium dioxide and 2 to 5 parts by weight of titanium, based on the total weight of the mixture.

14. Process for the preparation of a vapour-deposition material according to one of Claims 9 to 13, in which titanium oxide is mixed with ytterbium oxide in a molar ratio of 4:1 to 1:4, the mixture is compressed or suspended, shaped and subsequently sintered, where gadolinium oxide and/or dysprosium oxide and/or titanium are additionally added.

15. Process according to Claim 14, in which titanium dioxide is mixed with ytterbium oxide.

16. Process according to one or more of Claims 14 to 15, in which the sum of the molar proportions of ytterbium oxide, gadolinium oxide and/or dysprosium oxide does not exceed 80 mol%.

17. Process according to one or more of Claims 14 to 16, in which the sintering is carried out with inflow of air.

18. Process according to one or more of Claims 14 to 17, in which the sintering is carried out in vacuo.

19. Process according to one or more of Claims 14 to 18, in which the sintering is carried out under inert gas.

20. Process according to one or more of Claims 14 to 19, in which the mixture is shaped into tablets, discs, pellets, truncated cones, grains, granules, rods or beads.

21. Optical layer of high refractive index having a refractive index of n≥ 2.0 on a glass or plastic substrate, produced using a vapour-deposition material according to one or more of Claims 1 to 8.

22. Multilayered optical system comprising at least one optical layer of high refractive index having a refractive index of n ≥ 2.0 on a glass or plastic substrate, produced using a vapour-deposition material according to one or more of Claims 1 to 8.

## Revendications

1. Utilisation d'un matériau à dépôt en phase vapeur comprenant de l'oxyde de titane et de l'oxyde d'ytterbium selon un rapport molaire de 4:1 à 1:4 pour la production de couches optiques d'indice de réfraction élevé sur des substrats en verre et en matière plastique.

2. Utilisation selon la revendication 1, comprenant du dioxyde de titane et de l'oxyde d'ytterbium.

3. Utilisation selon la revendication 1 ou 2, comprenant de l'oxyde de titane et de l'oxyde d'ytterbium selon un rapport molaire de 2,6:1 à 1:1,3.

4. Utilisation selon l'une des revendications 1 à 3, laquelle comprend additionnellement de l'oxyde de gadolinium et/ou de l'oxyde de dysprosium.

5. Utilisation selon la revendication 4, où la somme des proportions molaires d'oxyde d'ytterbium, d'oxyde de gadolinium et/ou d'oxyde de dysprosium n'excède pas 80 %mol.

6. Utilisation selon l'une des revendications 1 à 5, comprenant du dioxyde de titane, de l'oxyde de titane et de l'oxyde d'ytterbium.

7. Utilisation selon l'une des revendications 1 à 6, comprenant 50 à 92 parties en poids d'oxyde d'ytterbium, 7 à 42 parties en poids de dioxyde de titane et 0 à 8 parties en poids de titane sur la, base du poids total du mélange.

8. Utilisation selon la revendication 7, comprenant 67 à 76 parties en poids d'oxyde d'ytterbium, 15 à 27 parties en poids de dioxyde de titane et 2 à 5 parties en poids de titane, sur la base du poids total du mélange.

9. Matériau à dépôt en phase vapeur pour la production de couches optiques d'indice de réfraction élevé, comprenant de l'oxyde de titane et de l'oxyde d'ytterbium selon un rapport molaire de 4:1 à 1:4 et de l'oxyde de gadolinium et/ou de l'oxyde de dysprosium et/ou de l'oxyde de titane.

10. Matériau à dépôt en phase vapeur selon la revendication 9, où la somme des proportions molaires d'oxyde d'ytterbium, d'oxyde de gadolinium et/ou d'oxyde de dysprosium n'excède pas 80 %mol.

11. Matériau à dépôt en phase vapeur selon l'une des revendications 9 à 10, comprenant du dioxyde de titane, de l'oxyde de titane et de l'oxyde d'ytterbium.

12. Matériau à dépôt en phase vapeur selon l'une des revendications 9 à 11, comprenant 50 à 92 parties en poids d'oxyde d'ytterbium, 7 à 42 parties en poids d'oxyde de titane et 0 à 8 parties en poids de titane, sur la base du poids total du mélange.

13. Matériau à dépôt en phase vapeur selon l'une des revendications 9 à 12, comprenant 67 à 76 parties en poids d'oxyde d'ytterbium, 15 à 27 parties en poids d'oxyde de titane et 2 à 5 parties en poids de titane, sur la base du poids total du mélange.

14. Procédé pour la préparation d'un matériau à dépôt en phase vapeur selon l'une des revendications 9 à 13, dans lequel de l'oxyde de titane est mélangé avec de l'oxyde d'ytterbium selon un rapport molaire de 4:1 à 1:4, le mélange est comprimé ou suspendu, conformé et ensuite fritté, où de l'oxyde de gadolinium et/ou de l'oxyde de dysprosium et/ou du titane sont additionnellement ajoutés.

15. Procédé selon la revendication 14, dans lequel du dioxyde de titane est mélangé avec de l'oxyde d'ytterbium.

16. Procédé selon une ou plusieurs des revendications 14 à 15, dans lequel la somme des proportions molaires de l'oxyde d'ytterbium, de l'oxyde de gadolinium et/ou de l'oxyde de dysprosium n'excède pas 80 %mol.

17. Procédé selon une ou plusieurs des revendications 14 à 16, dans lequel le frittage est mis en oeuvre avec une circulation entrante d'air.

18. Procédé selon une ou plusieurs des revendications 14 à 17, dans lequel le frittage est mis en oeuvre sous vide.

19. Procédé selon une ou plusieurs des revendications 14 à 18, dans lequel le frittage est mis en oeuvre sous gaz inerte.

20. Procédé selon une ou plusieurs des revendications 14 à 19, dans lequel le mélange est conformé selon des comprimés, des disques, des pastilles, des cônes tronqués, des grains, des granulés, des barreaux ou des perles.

21. Couche optique d'indice de réfraction élevé présentant un indice de réfraction n ≥ 2,0 sur un substrat en verre ou en matière plastique, produite en utilisant un matériau à dépôt en phase vapeur selon une ou plusieurs des revendications 1 à 8.

22. Système optique multicouche comprenant au moins une couche optique d'indice de réfraction élevé présentant un indice de réfraction n ≥ 2,0 sur un substrat en verre ou en matière plastique, produit en utilisant un matériau à dépôt en phase vapeur selon une ou plusieurs des revendications 1 à 8.
